**Europäisches Patentamt**

**European Patent Office**

**Office européen des brevets**

(19)

(11) Veröffentlichungsnummer: **0 236 755 B1**

## EUROPÄISCHE PATENTSCHRIFT

(12)

(45) Veröffentlichungstag der Patentschrift: **05.02.92**

(51) Int. Cl.⁵: **G08B 13/18**

(21) Anmeldenummer: **87101640.8**

(22) Anmeldetag: **06.02.87**

(54) **Vorrichtung zur Erkennung einer Abschattung eines von mindestens einem Sender ausgesandten Signals in einem zwischen dem Sender und Empfänger befindlichen Zwischenraum.**

(30) Priorität: **07.02.86 DE 3603927**

(43) Veröffentlichungstag der Anmeldung:
**16.09.87 Patentblatt 87/38**

(45) Bekanntmachung des Hinweises auf die
Patenterteilung:
**05.02.92 Patentblatt 92/06**

(84) Benannte Vertragsstaaten:
**AT BE CH DE FR GB IT LI NL SE**

(56) Entgegenhaltungen:
**AU-B- 509 436       DE-A- 2 451 100**
**DE-A- 2 540 741       DE-A- 2 648 631**
**DE-A- 2 851 444       GB-A- 1 404 913**
**US-A- 3 805 061**

(73) Patentinhaber: **EFAFLEX Transport- und Lager-**
**technik GmbH**
**Fliederstrasse 14**
**W-8301 Bruckberg-Edlkofen(DE)**

(72) Erfinder: **Seysen, Bettina**
**Pognerstrasse 24**
**W-8000 München 70(DE)**

(74) Vertreter: **KUHNEN, WACKER & PARTNER**
**Alois-Steinecker-Strasse 22 Postfach 1553**
**W-8050 Freising(DE)**

EP 0 236 755 B1

## Beschreibung

Die Erfindung betrifft eine Vorrichtung zur Erkennung einer Abschattung eines von mindestens einem Sender ausgesandten Signales in einem zwischen dem Sender und einem Empfänger befindlichen Zwischenraum gemäß dem Oberbegriff des Anspruchs 1.

Derartige Vorrichtungen werden beispielsweise von Lichtschranken gebildet, welche als Sender eine Lichtquelle und als Empfänger ein lichtempfindliches Element aufweisen, wobei der Lichtstrahl als Dauersignal von dem Sender entweder direkt oder im Wege einer Reflexion umgelenkt auf den Empfänger gelangt. Diese herkömmlich als Lichtschranken bezeichneten Sender- und Empfängeranordnungen sind als Linienüberwachung mit je einem Sender und einem Empfänger relativ teuer und großvolumig. Großvolumig insbesondere deshalb, weil bei den meisten Lichtschranken als Lichtquelle Licht des sichtbaren Spektrums verwendet wird, welches durch fremde Lichtquellen ebenfalls des sichtbaren Spektrums überlagert werden kannn. Es muß daher die Lichtquelle eine besonders hohe Signalamplitude aufweisen, damit möglichst eine Überlagerung mit anderen Lichtquellen vermieden wird. Insbesondere bei innenliegenden Räumen ist eine solche Lichtschranke leichter erreichbar, wo Störlicht von beispielsweise der Sonne nicht zu einer Fehlauslösung bei der Lichtschranke führt. Müssen größere Flächen überwacht werden, so sind Mehrfachanordnungen von Lichtschranken erforderlich, die meist sehr kostenintensiv in der Größenordnung von vielen tausend DM und auch wartungsintensiv sind.

Bei Vorrichtungen, die im Freien oder an Außenwänden verwendet werden, wird bevorzugt ein auf Ultraschall- oder Radarbasis funktionierender Melder verwendet, der die Probleme des Störlichteinflusses wie die Lichtschranke nicht aufweist. Nachteilig bei diesen Meldern ist jedoch, daß nur Bewegungen von Gegenständen in dem zu überwachenden Bereich festgestellt werden. Dringt jedoch ein Fremdkörper in den zu überwachenden Bereich ein und bleibt dort ohne Bewegung, so kann nicht mehr festgestellt werden, ob der eingedrungene Gegenstand sich noch in dem zu überwachenden Bereich befindet oder diesen wieder verlassen hat.

So ist beispielsweise bei schnelllaufenden Falttoren sehr entscheidend, ob ein die Toröffnung passierendes Fahrzeug oder eine in diesem Bereich befindliche Person nach einiger Zeit noch ganz oder teilweise im Schwenkbereich der Falttore verweilt. Da dies durch Bewegungsmelder nicht festgestellt werden kann, müssen andere Melder vorgesehen werden, welche eine Verletzung von Personen oder Beschädigung von Gegenständen und Falttoren dann vermeidet, wenn das Falttor öffnet bzw. schließt und dabei auf Personen oder Gegenstände im Schwenkbereich auftrifft.

Herkömmlich wird dieses Problem durch Gummileisten an den Stirnkanten der Falttore gelöst, welche als Berührungssensoren ausgebildet sind, beispielsweise durch eine Luftkammer, welche bei dem Druck auf die Gummileiste über einen entsprechenden Anschlußschlauch zu einer schaltmembran führen. Dies hat jedoch den großen Nachteil, daß das Störsignal erst beim Auftreffen eines Gegenstandes auf die Gummileiste ausgelöst wird und mit einer relativ großen Verzögerung der Antrieb des schwingenden Torflügels gestoppt wird, so daß zuverlässig Beschädigungen und insbesondere Verletzung von Personen dadurch insbesondere dann nicht vermieden werden können, wenn Schnelllaufttore gesteuert werden.

Da auch Bewegungsmelder dieses Problem nicht lösen können, verbleibt bisher nur die Anwendung von Lichtschranken, welche wegen der Tageslichteinflüsse besonders lichtstarke Lichtquellen mit sehr hoher Signalamplitude aufweisen und daher kostenintensiv sind. Um beispielsweise auch eine ausgestreckte Hand einer Person oder Deichseln von Fahrzeugen oder Gabeln von Gabelstaplern und dergleichen, d.h. waagrecht zur Bodenebene verlaufende Gegenstände in verschiedensten Höhen überwachen zu können, sind mehrere Lichtschranken erforderlich, die jedoch allein schon wegen ihrer Baugrößen einen bestimmten Mindestabstand voneinander aufweisen müssen, so daß Gegenstände, die in den Zwischenraum zwischen den Strahlungsbereich von zwei Lichtschranken reichen, nicht erfaßbar sind. Werden dennoch unter Inkaufnahme der lückenhaften Flächenüberwachung solche Mehrfachanordnungen von Lichtschranken verwendet, so entstehen Anordnungen, die viele tausend Mark Kosten verursachen.

Dokument WO82/02787 betrifft eine Vorrichtung zur Erkennung einer Abschattung eines von mehr als zwei Sendern sequentiell ausgesandten Signales in einem zwischen den Sendern und einem Empfänger befindlichen Zwischenraum, welche die Schließebene zweier gekoppelter Schiebetüren nach einem Objekt absucht und daraufhin ein entsprechendes Signal erzeugt. An der linken und rechten Seite einer zu überwachenden Türöffnungsfläche sind Sender und Empfänger in mehreren Sender-Empfänger-Gruppen angeordnet. Die Sender werden durch eine entsprechende Schaltung sequentiell angesteuert. Anhand der Unterbrechung des Strahlenganges zwischen mindestens einem der Sender und dem zugeordneten Empfänger kann festgestellt werden, ob sich innerhalb der Türöffnungsfläche ein Hindernis befindet. Da die sequentiell angesteuerten Sender nicht auf einen einzelnen Empfänger ausgerichtet sind, kann ihre Strahlungsintensität nicht voll ausgenutzt werden. Die Überbrückung größerer Abstände ist somit stark eingeschränkt. Des weiteren wird keine vollständige Überdeckung eines Rechtecks erzielt.

Aufgabe der Erfindung ist es, die Störungsempfindlichkeit einer Vorrichtung zur Erkennung einer Abschattung eines von mehr als zwei Sendern sequentiell ausgesandten Signales in einem zwischen den Sendern und einem Empfänger befindlichen Zwischenraum herabzusetzen.

Die Lösung der Aufgabe erfolgt durch die Merkmale des Anspruchs 1.

Vorteilhafte Weiterbildungen ergeben sich aus den Unteransprüchen.

Ein besonderer Vorteil der erfindungsgemäßen Lösung ist darin zu sehen, daß eine praktisch vollständige flächendeckende Überwachung der zu überwachenden Fläche oder des Zwischenraums ermöglicht wird, weil mehrere Sender, die relativ klein ausgeführt werden können, auf nur einen Empfänger ihre Signale abgeben. Werden diese mehreren Sender abwechselnd, z.B. zyklisch abwechselnd, angesteuert, so kann mit einer an den Empfänger angeschlossenen Auswerteschaltung die Lokalität der Störung innerhalb der zu überwachenden Öffnung erfaßt werden. Dabei ist nicht einmal ein besonders aufwendiger Empfänger erforderlich, weil dieser dann nicht aus mehreren Sendern kommende Signale gleichzeitig unterscheiden muß, sondern nur das vom jeweiligen Sender kommende Signal auf dessen Vorhandensein abprüfen muß. Im einfachsten Fall ist dies ein Lichtsignal von definierter Länge, d.h. Zeitdauer, so daß der Empfänger lediglich Amplitude und Dauer des Signals entsprechend dem Sendesignal zu prüfen braucht. Dies bedeutet, daß die Sendesignale mit einer bestimmten Taktfrequenz erzeugt jeweils zyklisch abwechselnd die verschiedenen Sender ansteuern und über den gemeinsamen Empfänger auf der Empfangsseite geprüft und auf Koinzidenz oder Abweichung ausgewertet werden können. Es wird also, nicht wie bei Lichtschranken, eine konzentrierte Lichtbündelung, sondern eine Lichtstreuung verwendet, welche von mehreren Sendern über den Streuungsbereich auf einen gemeinsamen Empfänger reicht. Um aus der Problematik der Störlichtbeeinflussung keine Schwierigkeiten zu erhalten, wird vorzugsweise als Sender eine Infrarotdiode und als Empfänger ein infrarotempfindliches Lichtelement verwendet. Natürlich können dazu auch polarisierte Lichtquellen mit polarisierten Lichtempfängern in gleicher Weise eingesetzt werden.

Bei größeren Flächen und Räumen ist die Anordnung von mehreren Gruppen aus jeweils mehreren Sendern und einem zugehörigen Empfänger erforderlich, wobei sich als besonders günstig Dreieckskonfigurationen herausgestellt haben. So wird eine rechteckige Fläche durch beispielsweise zwei Baugruppen gebildet, die einander gegenüberliegen, und somit die eine Baugruppe das eine Flächendreieck und die andere Baugruppe das andere Flächendreieck der rechteckigen Fläche abdecken. Bei sehr hohen Öffnungen sind eventuell mehrere solche Baugruppen auf beiden Seiten der Öffnung erforderlich, um alle Raumhöhen abdecken zu können. Dies ist aber insoweit ein besonderer Vorteil der Erfindung, daß hier keine komplizierten Anordnungen geschaffen werden müssen, sondern eine große Vielzahl von beispielsweise Infrarotdioden auf einer Leist angeordnet werden, in deren Reihe jeweils nach mehreren Sendern ein Empfänger der gegenüberliegenden Gruppe zwischengeordnet ist.

Natürlich können solche Leistenanordnungen sowohl an feststehenden als auch an beweglichen Gegenständen, wie z.B. Schnelllauffalttoren, angeordnet werden. Durch die günstige Baukonstruktion lassen sich solche Leisten auch in Laibungen oder an Bodenflächen anbringen, so daß nicht nur Flächenüberwachungen, sondern durch die Leisten und deren Flächen in Kombination auch Raumüberwachungen möglich sind, was insbesondere bei Schnelllauffalttoren zu einer vollständigen Überwachung des Öffnungsraumes dieser Tore verwendet werden kann.

Die Überwachung ist derart fein, daß selbst in den Überwachungsraum eindringende gasförmige Störungen, wie z.B. Rauchschwaden, Auspuffgase und dergleichen, dazu verwendet werden können, bei dem Schnelllauftor einen Schließvorgang auszulösen, so daß diese Gase nicht in den dahinter befindlichen Raum eindringen können.

Nachfolgend ist ein Ausführungsbeispiel der Erfindung näher beschrieben. Darin zeigt:

Fig. 1      eine Systemkonfiguration,

Fig. 2      ein Blockschaltbild der Erfindung und

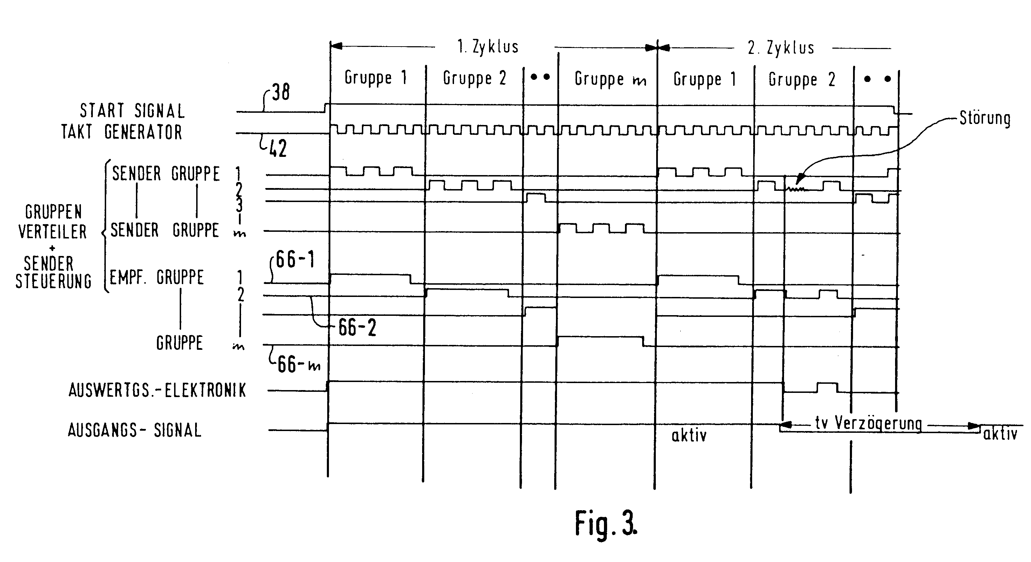

Fig. 3      ein Impulsdiagramm der verschiedenen Signalverläufe.

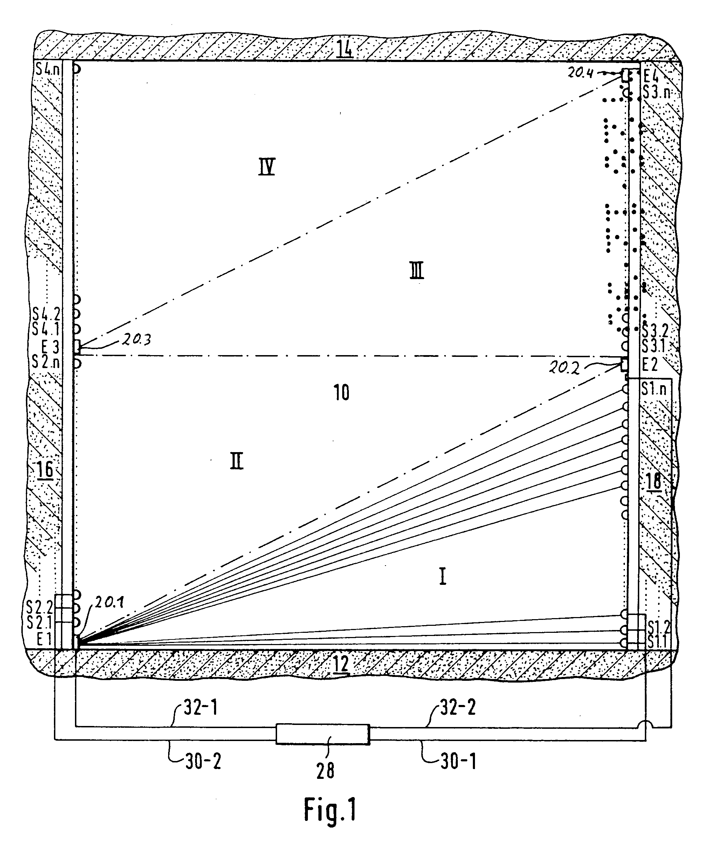

Gemäß Fig. 1 ist eine Gebäudeöffnung 10 durch eine Bodenebene 12, eine Deckenebene 14 sowie eine linke Wand 16 und eine rechte Wand 18 definiert. An der linken Wand 16 ist ein Empfänger 20.1 und ein Empfänger 20.3 sowie an der rechten Wand 18 ein Empfänger 20.2 und ein Empfänger 20.4 angeordnet. Im ersten Empfänger 20.1 der linken Wand sind gegenüberliegend auf der rechten Wand 18 die Sender S1.1 bis S1.n zugeordnet, während dem zweiten Empfänger 20.2 auf der rechten Seite 18 die Sender S2.1, S2.2 bis S2.n auf der linken Seite 16 zugeordnet sind. Gleiches gilt für den dritten Empfänger 20.3 auf der linken Seite 16, dem die Sender S3.1, S3.2 bis S3.n auf der rechten Seite 18 zugeordnet sind und für den vierten Empfänger 20.4 auf der rechten Seite 18, dem die Sender S4.1, S4.2 bis S4.n auf der linken Seite 16 zugeordnet sind. Der erste Empfänger 20.1 definiert mit den Sendern S1.1, S1.2 bis S1.n eine Dreiecksfläche I, die einen rechten Winkel zwischen der Seite 18 und dem Boden 12 einschließt. Ebenso definiert der zweite Empfänger 20.2 mit den Sendern S2.1 bis S2.n eine ebenfalls rechtwinklige Dreiecksfläche, die mit der Dreiecksfläche I eine gemeinsame Hypotenuse aufweist. Die Dreiecksfläche III, die von der Gruppe des dritten Empfängers 20.3 mit den zugehörigen Sendern S3.1 bis S3.n definiert wird, ist in der räumlichen Anordnung der Dreiecksfläche I um die halbe Höhe der Öffnung 10 nach oben versetzt äquivalent. Schließlich ist die Dreiecksfläche IV, die durch den vierten Empfänger 20.4 mit den zugehörigen Sendern S4.1 bis S4.n gebildet wird, der Dreiecksfläche II ebenfalls um die halbe Öffnungshöhe nach oben versetzt äquivalent. Durch die vier Dreiecksflächen I bis IV wird eine vollständige Überdeckung der Öffnung 10 erreicht.

Da die als Infrarotdioden ausgebildeten Sender S1.1 bis S1.n einen Streuwinkel von mindestens 20$^\circ$ aufweisen, wird erreicht, daß die Dreiecksfläche I hinsichtlich der von diesen Infrarotdioden ausgesandten Infrarotstrahlen vollständig überdeckt wird und alle Strahlen von dem ersten Empfänger 20.1 empfangen werden können. Natürlich könnte auch der dritte Empfänger 20.3 von den Infrarotdioden S1.1 bis S1.n Infrarotstrahlen empfangen, doch dies würde dann zu einer anderen Gruppenschaltung mit entsprechender Auswertung führen, wie nachfolgend genauer beschrieben wird.

Eine Steuerschaltung 28 versorgt über eine Sendeleitung 30-1 die Sender der ersten Gruppe und über eine Sendeleitung 30-2 die Sender der zweiten Gruppe. Entsprechende Sendeleitungen, die nicht näher dargestellt sind, versorgen die Sender der Gruppe drei bzw. der Gruppe vier. Über eine Empfängerleitung 32-1 wird der erste Empfänger 20.1 mit der Steuerschaltung 28 verbunden, während der zweite Empfänger 20.2 über eine zweite Leitung 32-2 mit der Steuerschaltung 28 verbunden ist. In ähnlicher, aber nicht dargestellter, Weise ist der dritte Empfänger 20.3 und der vierte Empfänger 20.4 mit der Steuerschaltung 28 verbunden.

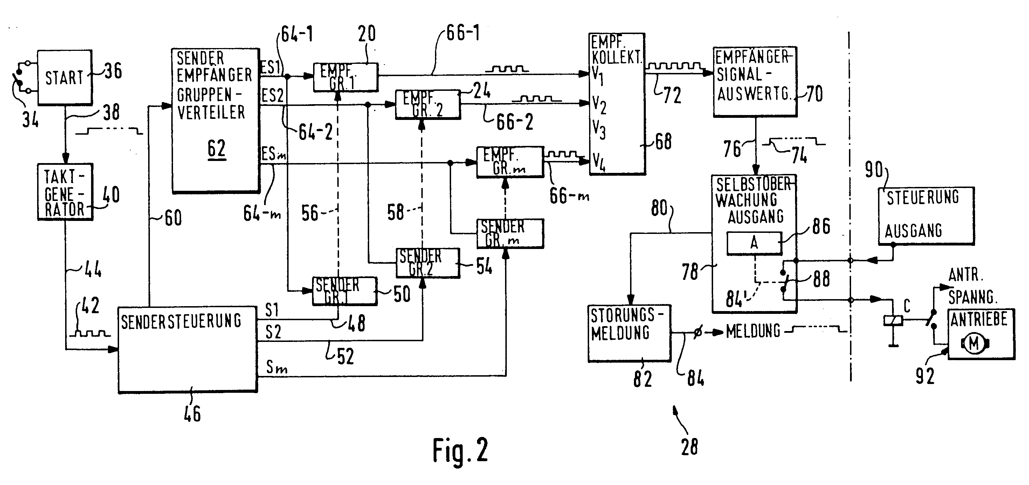

Gemäß Fig. 2 ist die Steuerschaltung 28 näher dargestellt. Über einen Hauptschalter 34 wird eine Signalerzeugungsvorrichtung 36 eingeschaltet, die ein Startsignal 38 erzeugt. Das Startsignal 38 wird einem Taktgenerator 40 zugeleitet, der eine Rechteck-Impulsfolge in Form eines Taktsignals 42 erzeugt. Das vom Taktgenerator 40 kommende Taktsignal 42 wird über eine Taktleitung 44 einer Sendersteuerung 46 zugeführt. Die Sendersteuerung 46 gibt Sendesignale S1 über eine erste Sendeleitung 48 an eine erste Sendergruppe 50. Ebenso werden von der Sendersteuerung 46 Sendesignale S2 über eine zweite Leitung 52 an eine zweite Sendergruppe 54 angelegt. Von der Sendesteuerung führen weitere Sendeleitungen ab, welche an weitere Sendergruppen n entsprechende Sendesignale in Abhängigkeit von der Zahl der angeschlossenen Sendergruppen führen. Bei der Ausführungsform gemäß Fig. 1 wären dies vier Sendergruppen mit jeweils 4 Senderleitungen.

Von der ersten Sendergruppe 50 werden Sendesignale 56 auf den ersten Empfänger 20.1 der ersten Gruppe übertragen. Ebenso werden von der zweiten Sendergruppe 54 Sendesignale 58 auf den zweiten Empfänger 20.2 der zweiten Gruppe übertragen. Gleiches gilt für die Sendergruppen und Empfänger der weiteren Baueinheiten. Von der Sendersteuerung führt eine Vergleichssignalleitung Vergleichssigale auf einen Sender-Empfänger-Gruppenverteiler 62, von wo die Vergleichssignale 64-1 bis 64-m auf die jeweiligen Empfänger der jeweiligen Gruppen weitergegeben werden. Bei den Empfängern 20.1, 20.2 usw. wird das Vergleichssignal 64 mit den empfangenen Sendersignalen 56 bzw. 58 usw. jeweils zugehörig zueinander verglichen, was beispielsweise durch eine logische UND-Verknüpfung geschehen kann. Die Empfängerausgangssignale 66-1 bzw. 66-2 bis 66-m werden auf eine Empfängerkollektorschaltung 68 gegeben, von wo sie einer gemeinsamen Empfängersignal-Auswerteschaltung 70 über eine Kollektorleitung 72 zugeführt werden. Aus der Empfängersignal-Auswerteschaltung 70 wird das Auswertesignal 74 über eine Auswertesignalleitung 76 einer Selbstüberwachungsschaltung 78 zugeführt. Diese Selbstüberwachungsschaltung 78 ist bevorzugt als Fail-Safe-Schaltung ausgebildet. Von ihr werden über eine Störungsmeldungsleitung 80 Signale in eine Störungsmeldungsschaltung 82 geführt, die dann die Erkennungssignale 84 liefert. Die Selbstüberwachungsschaltung 78 weist ein Relais 86 auf, welches über seinen Relaiskontakt 88 die Falttorsteuerung 90 mit dem Falttorantrieb 92 verbindet. Die Betätigung des Relaiskontakts 88 kann ebenfalls als Erkennungssignal 84' verwendet werden, wobei anstelle der Steuerung eines Schnelllauftores auch eine Alarmanlage oder sonstige Überwachungseinrichtungen betätigt werden können.

**Patentansprüche**

1. Vorrichtung zur Erkennung einer Abschattung eines von mehr als zwei Sendern (S1.1-S1.n, S2.1-S2n, ... Sm.1-Sm.n) sequentiell ausgesandten Signales in einem zwischen den Sendern und einem Empfänger (20.1, 20.2, ..., 20.m) befindlichen Zwischenraum (10) aufweist, wobei eine Steuerschaltung (28) vorgesehen ist, an welche alle Sender (S1.1-S1.n, S2.1-S2.n, ..., Sm.1-Sm.n) und der Empfänger (20.1, 20.2, ..., 20.m) angeschlossen sind, und die Steuerschaltung (28) an die Sender (S1.1-S1.n, S2.1-S2.n, ..., Sm.1.-Sm.n) Signale abgibt, welche von den Sendern (S1.1-S1.n, S2.1-S2.n, ..., Sm.1.-Sm.n) in Sendesignale umgewandelt werden, von dem Empfänger (20.1, 20.2, ... 20.m) empfangbar sind und an die Steuerschaltung (28) weitergeleitet werden, wobei die Steuerschaltung (28) an die Sender (S1.1-S1.n, S2.1-S2.n, ..., Sm.1.-Sm.n) die Signale zyklisch sequentiell abgibt, und wobei die Sender (S1.1-S1.n, S2.1-S2.n, ..., Sm.1.-Sm.n) jeweils dem Empfänger (20.1, 20.2, ... 20.m) zugeordnet sind und mit dem Empfänger (20.1, 20.2, ... 20.m) eine Sender-Empfänger-Gruppe definieren,

dadurch gekennzeichnet, daß

jede zu überwachende Teilfläche oder jeder zu überwachende Teilraum von einer zugeordneten Sender-Empfänger-Gruppe allein überdeckt wird, und dabei jeder Sender (S1.1-S1.n, S2.1-S2.n, ..., Sm.1.-Sm.n) einer Sendergruppe seine Signale nur zu seinem zugeordneten Empfänger (20.1, 20.2, ... 20.m) abgibt,

mindestens zwei Sender-Empfänger-Gruppen derart vorgesehen sind, daß die Empfänger (20.1, 20.2, ..., 20.m) einander diagonal gegenüberliegen,

die Sender (S1.1-S1.n, S2.1-S2.n, ... Sm.1-Sm.n) mit den Empfängern (20.1, 20.2, ..., 20.m) je eine ein rechtwinkliges Dreieck definierende Fläche bilden, und

die von den Empfängern (20.1, 20.2, ..., 20.m) kommenden Signale einer Frequenz- und/oder Amplitudenauswerteschaltung in der Steuerschaltung (28) zugeführt werden, welche ein Auswertesignal (74) erzeugt.

2. Vorrichtung nach Anspruch 1, dadurch gekennzeichnet, daß die Steuerschaltung (28) von einem Taktgenerator (40) erzeugte impulsförmige Taktsignale (42) abgibt.

3. Vorrichtung nach einem der Ansprüche 1 bis 2, dadurch gekennzeichnet, daß eine Komparatorschaltung vorgesehen ist, welche die von der Auswerteschaltung kommenden und die an die Sender (S1.1-S1.n, S2.1-S2.n, ..., Sm.1.-Sm.n) abgegebenen Signale hinsichtlich Frequenz und/oder Amplitude vergleicht und bei einer Abweichung ein Schaltsignal erzeugt, welches in ein Auswertesignal (74) umsetzbar ist.

4. Vorrichtung nach einem der Ansprüche 1 bis 3, dadurch gekennzeichnet, daß eine Fail-Safe-Schaltung vorgesehen ist, mit welcher die Funktionen aller Sender-, Empfänger- und Schaltungsbaugruppen überwacht werden.

5. Vorrichtung nach einem der Ansprüche 1 bis 4, dadurch gekennzeichnet, daß die Sender (S1.1-S1.n, S2.1-S2.n, ..., Sm.1.-Sm.n) in einer Linie angeordnet sind.

6. Vorrichtung nach einem der Ansprüche 1 bis 5, dadurch gekennzeichnet, daß die Geometrie des Zwischenraums (10) durch die Sender-/Empfängerebene mehrerer Gruppen von Sendern (S1.1-S1.n, S2.1-S2.n, ..., Sm.1.-Sm.n) und Empfängern (20.1, 20.2, ... 20.m) vollständig überdeckt wird.

7. Vorrichtung nach einem der Ansprüche 1 bis 6, dadurch gekennzeichnet, daß die Sender (S1.1-S1.n, S2.1-S2.n, ..., Sm.1.-Sm.n) lichtemittierende Dioden und der Empfänger (20.1, 20.2, ... 20.m) ein lichtempfangendes Element aufweist.

8. Vorrichtung nach Anspruch 7, dadurch gekennzeichnet, daß die lichtemittierenden Dioden als Infrarotdioden und das lichtempfangende Element als Infrarotempfänger ausgebildet ist.

9. Vorrichtung nach Anspruch 7 oder 8, dadurch gekennzeichnet, daß die lichtemittierenden Dioden einen Streuwinkel von mindestens $20°$ aufweisen.

10. Vorrichtung nach einem der Ansprüche 1 bis 9, dadurch gekennzeichnet, daß mehrere Gruppen von Sendern (S1.1-S1.n, S2.1-S2.n, ..., Sm.1.-Sm.n) und Empfängern (20.1, 20.2, ... 20.m) eine gemeinsame Steuerschaltung (28) aufweisen.

11. Vorrichtung nach Anspruch 10, dadurch gekennzeichnet, daß die Sender (S1.1-S1.n, S2.1-S2.n, ..., Sm.1.-Sm.n) jeder Gruppe und/oder aller Gruppen von einer Sendersteuerung (46) angesteuert werden.

**Claims**

1. A device for recognition of shading of a signal successively transmitted by more than two transmitters (S1.1-S1.n, S2.1-S2n, ... Sm.1-Sm.n) in a space (10) between the transmitters and a receiver (20.1, 20.2, ..., 20.m), a control circuit (28) being provided and connected to all the transmitters (S1.1-S1.n, S2.1-S2.n, ...,

Sm.1-Sm.n) and the receivers (20.1, 20.2,..., 20.m), and the control circuit 28 supplies the transmitters (S1.1-S1.n, S2.1-S2.n, ..., Sm.1.-Sm.n) with signals which are converted by the transmitters (S1.1-S1.n, S2.1-S2.n, ..., Sm.1.-Sm.n) into transmitter signals, are adapted to be received by the receiver (20.1, 20.2,..., 20.m) and are retransmitted to the control circuit (28), which supplies the signals successively and in cyclic manner to the transmitters (S1.1-S1.n, S2.1-S2.n, ..., Sm.1.-Sm.n) and the transmitters (S1.1-S1.n, S2.1-S2.n ..., Sm.1.-Sm.n) are each associated with the receiver (20.1, 20.2, ... 20.m) and cooperate with the receiver (20.1, 20.2, ... 20.m) to define a transmitter-receiver group,

characterised in that

each monitored partial surface or each monitored partial space is covered by one associated transmitter-receiver group only, and each transmitter (S1.1-S1.n, S2.1-S2.n, ..., Sm.1.-Sm.n) in a transmitter group delivers signals only to the associated receiver (20.1, 20.2, ... 20.m),

at least two transmitter-receiver groups are disposed so that the receivers (20.1, 20.2, ..., 20.m) are diagonally opposite one another,

the transmitters (S1.1-S1.n, S2.1-S2.n, ... Sm.1-Sm.n) and the receivers (20.1, 20.2, ..., 20.m) form respective surfaces defining a right-angled triangle, and

the signals coming from the receivers (20.1, 20.2, ..., 20.m) are supplied to a frequency and/or amplitude evaluating circuit in the control circuit (28), which generates an evaluating signal (74).

2.  A device according to claim 1, characterised in that the control circuit (28) delivers pulsed clock signals (42) generated by a clock generator (40).

3.  A device according to claim 1 or 2, characterised in that a comparator circuit is provided and compares the signals from the evaluating circuit with the signals delivered to the transmitters (S1.1-S1.n, S2.1-S2.n, ..., Sm.1.-Sm.n) with regard to frequency and /or amplitude and, in the event of a discrepancy, generates a switching signal which is convertible into an evaluating signal (74).

4.  A device according to any of claims 1 to 3, characterised in that a fail-safe circuit is provided for monitoring the functions of all the transmitter, receiver and circuit sub-assemblies.

5.  A device according to any of claims 1 to 4, characterised in that the transmitters (S1.1-S1.n, S2.1-S2.n, ..., Sm.1.-Sm.n) are disposed in a line.

6.  A device according to any of claims 1 to 5, characterised in that the geometry of the intermediate space (10) is completely covered through the transmitter-receiver place of a number of groups of transmitters (S1.1-S1.n, S2.1-S2.n, ..., Sm.1.-Sm.n) and receivers (20.1, 20.2, ... 20.m).

7.  A device according to any of claims 1 to 6, characterised in that the transmitters (S1.1-S1.n, S2.1-S2.n, ..., Sm.1.-Sm.n) are light-emitting diodes and the receiver (20.1, 20.2, ... 20.m) comprises a light-receiving component.

8.  A device according to claim 7, characterised in that the light-emitting diodes are infrared diodes and the light-receiving component is an infrared receiver.

9.  A device according to claim 7 or 8, characterised in that the light-emitting diodes have a scattering angle of at least 20°.

10. A device according to any of claims 1 to 9, characterised in that a number of groups of transmitters (S1.1-S1.n, S2.1-S2.n, ..., Sm.1.-Sm.n) and receivers (20.1, 20.2, ... 20.m) have a common control circuit (28).

11. A device according to claim 10, characterised in that the transmitters (S1.1-S1.n, S2.1-S2.n, ..., Sm.1.-Sm.n) in each group and/or in all groups are actuated by a transmitter control (46).

**Revendications**

1.  Dispositif de reconnaissance d'une atténuation d'un signal émis séquentiellement par plus de deux émetteurs (S1.1-S1.n, S2.1-S2.n, ..., Sm.1-Sm.n) dans un espace situé entre les émetteurs et un récepteur (20.1, 20.2, ..., 20.m), comprenant un circuit de commande (28) auquel tous les émetteurs (S1.1-S1.n, S2.1-S2.n, ..., Sm.1-Sm.n) sont reliés et le récepteur (20.1, 20.2, ..., 20.m), et dans lequel le circuit de commande (28) envoie aux émetteurs (S1.1-S1.n, S2.1-S2.n, ..., Sm.1-Sm.n) des signaux qui sont transformés par les émetteurs (S1.1-S1.n, S2.1-S2.n, ..., Sm.1-Sm.n) en signaux d'émission, qui sont susceptibles d'être reçus par le récepteur (20.1, 20.2, ..., 20.m) et qui sont transmis à nouveau au circuit de commande (28), dans lequel le circuit de commande fournit cycliquement et séquentiellement les signaux aux émetteurs (S1.1-S1.n, S2.1-S2.n, ..., Sm.1-Sm.n) et dans lequel les émetteurs (S1.1-S1.n, S2.1-S2.n, ..., Sm.1-Sm.n) sont chacun associés au récepteur et constituent avec le récepteur (20.1, 20.2, ..., 20.m) un groupe émetteurs récepteur, caractérisé en ce que:

- chaque partie de l'aire ou de l'espace à surveiller est recouverte uniquement par un groupe émetteurs-récepteur associé, chaque émetteur (S1.1-S1.n, S2.1-S2.n, ..., Sm.1-Sm.n) d'un groupe d'émetteurs ne fournissant son signal qu'à son récepteur associé (20.1, 20.2, ..., 20.m);
- au moins deux groupes émetteurs-récepteur sont prévus de telle sorte que les récepteurs (20.1, 20.2, ..., 20.m) se font face en diagonale;
- les émetteurs (S1.1-S1.n, S2.1-S2.n, ..., Sm.1-Sm.n) forment avec les récepteurs (20.1, 20.2. ..., 20.m) chacun une surface constituant un triangle rectangle; et en ce que
- les signaux arrivant des récepteurs (20.1, 20.2, ..., 20.m) sont fournis à un circuit d'évaluation de fréquence et/ou d'amplitude dans le circuit de commande (28) qui donne un signal d'évaluation (74).

2. Dispositif selon la revendication 1, caractérisé en ce que le circuit de commande (28) produit des signaux d'horloge (42) en forme d'impulsions, produits par un générateur d'horloge (40).

3. Dispositif selon une des revendications 1 ou 2, caractérisé en ce qu'il comprend un circuit comparateur qui compare en fréquence et/ou en amplitude les signaux provenant du circuit d'évaluation et ceux délivrés aux émetteurs (S1.1-S1.n, S2.1-S2.n, ..., Sm.1-Sm.n), et qui, en cas d'écart, fournit un signal de commutation qui est transformable en signal d'évaluation (74).

4. Dispositif selon l'une des revendications 1 à 3, caractérisé en ce qu'il comprend un circuit à sécurité intégrée, grâce auquel les fonctions de toutes les unités d'émetteurs, de récepteurs et de circuits sont surveillées.

5. Dispositif selon l'une des revendications 1 à 4, caractérisé en ce que les émetteurs (S1.1-S1.n, S2.1-S2.n, ..., Sm.1-Sm.n) sont disposés suivant une ligne.

6. Dispositif selon l'une des revendications 1 à 5, caractérisé en ce que l'espace intermédiaire (10) est géométriquement entièrement recouvert par les plans émetteurs/récepteur des différents groupes d'émetteurs (S1.1-S1.n, S2.1-S2.n, ..., Sm.1-Sm.n) et de récepteurs (20.1, 20.2, ..., 20.m).

7. Dispositif selon l'une des revendications 1 à 6, caractérisé en ce que les émetteurs (S1.1-S1.n, S2.1-S2.n, ..., Sm.1-Sm.n) comprennent des diodes électro-luminescentes, et le récepteur (20.1, 20.2, ..., 20.m) comprend un élément capteur de la lumière.

8. Dispositif selon la revendication 7, caractérisé en ce que les diodes électro-luminescentes sont constituées de diodes infrarouges et l'élément capteur de la lumière est constitué d'un récepteur infrarouge.

9. Dispositif selon la revendication 7 ou 8, caractérisé en ce que les diodes électro-luminescentes présentent un angle de dispersion d'au moins 20˚.

10. Dispositif selon l'une des revendications 1 à 9, caractérisé en ce que plusieurs groupes d'émetteurs (S1.1-S1.n, S2.1-S2.n, ..., Sm.1-Sm.n) et de récepteurs (20.1, 20.2, ..., 20.m) présentent un circuit de commande (28) commun.

11. Dispositif selon la revendication 10, caractérisé en ce que les émetteurs (S1.1-S1.n, S2.1-S2.n, ..., Sm.1-Sm.n) de chaque groupe et/ou de tous les groupes sont commandés par une commande d'émission (46).

**Fig.1**

EP 0 236 755 B1

START 36

34 38

TAKT-GENE-RATOR 40

44

42

SENDERSTEUERUNG 46

SENDER EMPFÄNGER GRUPPEN-VERTEILER 62

60

ES1
ES2
ESm

64-1
64-2
64-m

56

S1
S2
Sm

SENDER GR.1 50
48
52

SENDER GR.2 54

SENDER GR.m

58

EMPF. GR.1 20

EMPF. GR.2 24

EMPF. GR.m

66-1
66-2
66-m

EMPF. KOLLEKT.
V1
V2
V3
V4
68

72

EMPFÄNGER-SIGNAL-AUSWERTG. 70

76
74

SELBSTÜBERWACHUNG AUSGANG
A 86
78
84
88

80

STÖRUNGS-MELDUNG 82
84
MELDUNG

90

STEUERUNG AUSGANG

ANTR. SPANNG.
C
ANTRIEBE M
92

Fig. 2

28

6

EP 0 236 755 B1

1. Zyklus     2. Zyklus

| Gruppe 1 | Gruppe 2 | • • | Gruppe m | Gruppe 1 | Gruppe 2 | • • |

START SIGNAL — 38

TAKT GENERATOR — 42

GRUPPEN VERTEILER + SENDER STEUERUNG

{ SENDER GRUPPE 1, 2, 3, m

SENDER GRUPPE m

EMPF. GRUPPE 1 — 66-1

2 — 66-2

GRUPPE m — 66-m

AUSWERTGS.-ELEKTRONIK

AUSGANGS- SIGNAL

Störung

tv Verzögerung

aktiv     aktiv

## Fig. 3.